# EUROPEAN PATENT APPLICATION

(11) **EP 4 087 135 A1**
(43) Date of publication of application: **09.11.2022**
(21) Application number: 21172401.8
(22) Date of filing: 06.05.2021
(51) Int. Cl.: H03K 17/95, H03K 17/689, G07C 9/00

(54) **VEHICLE ACCESS DEVICE**

(71) Applicant: Continental Automotive Technologies GmbH, 30165 Hannover (DE)
(72) Inventor: Buljovcic, Dalibor, 81739 München (DE); Vukov, Predrag, 81739 München (DE); Colic, Zdravko, 81739 München (DE); Lemajic, Igor, 81739 München (DE)
(74) Representative: Continental Corporation

(57) **Abstract**

An electronic remote key (20) for a vehicle (10) comprises a battery (21) comprising a first terminal (V+) and a second terminal (V-), a load (22), a switching element (S1), and a wake-up unit (23). The load (22) and the switching element (S1) are coupled in series between the first terminal (V+) and the second terminal (V-) of the battery (21), the wake-up unit (23), when exposed to an electromagnetic field, is configured to close the switching element (S1), and the wake-up unit (23) is configured to open the switching element (S1) if the electronic remote key (20) is inactive for a specified period of time.

## Description

The current invention relates to a vehicle access device, in particular an electronic remote key for a vehicle.

Most vehicles today may be unlocked and remotely started using an electronic remote key. Some "start and stop" access systems are well known in which the user needs to press an unlocking button from the electronic remote key to unlock or lock the vehicle, start the engine of the vehicle, or open a trunk of the vehicle, for example. Such a remote key usually has to be inserted into an immobilizer station located inside the vehicle which recognizes the remote key and allows the user to start the vehicle. Such systems replace the originally known ignition switch systems. Other "start and stop" access systems do not require the user to press a button or to insert the key in an immobilizer in order to unlock or lock the vehicle or to start the engine. Such a "start and stop" access system is called a passive start and entry system. With passive start and entry systems, the vehicle may be unlocked automatically when the key is detected within a certain range from the vehicle. In order to start the vehicle, a start button within the vehicle usually has to be pressed.

Such an electronic remote key communicates with the vehicle using wireless technology. For this reason, an electronic remote key usually comprises two or more different antennas, a corresponding driver circuit and a battery. The battery is usually inserted into the remote key at the end of production, before the vehicle and the remote key are transferred to the end customer. Even if the remote key is not yet in use, there is a certain amount of quiescent current consumption even during shelf life. Even further, there is also a significant effect of quiescent current consumption after the remote key has been put into operation during those periods where it is not in use. This effect of quiescent current consumption drains the battery and reduces battery lifetime. The amount of energy consumption due to the effect of quiescent current consumption during idle times can even exceed energy consumption caused by the use of the remote key. Therefore, there is a risk that the battery empties during the lifetime of the vehicle and remote key. It is, however, not desired and sometimes not even possible to change the battery.

There is a need to provide an electronic remote key that has a mechanism for reducing the effect of quiescent current consumption in order to increase the overall battery lifetime.

This problem is solved by an electronic remote key according to claim 1. Configurations and further developments of the invention are the subject of the dependent claims.

An electronic remote key includes a battery including a first terminal and a second terminal, a load, a switching element, and a wake-up unit. The load and the switching element are coupled in series between the first terminal and the second terminal of the battery, the wake-up unit, when exposed to an electromagnetic field, is configured to close the switching element, and the wake-up unit is configured to open the switching element if the electronic remote key is inactive for a specified period of time.

In this way, quiescent current consumption effect of the remote key can be reduced in order to increase battery lifetime.

The load can be supplied with energy from the battery when the switching element is closed, and the load cannot be supplied with energy from the battery if the switching element is open.

The wake-up unit can be configured to close the switching element when exposed to an electromagnetic field with a wavelength of between 30kHz and 300kHz.

Such an electromagnetic field is usually generated by vehicles for communication with remote devices. Therefore, no additional devices are needed within the vehicle.

The switching element can comprise a transistor.

The transistor can be a MOSFET.

The transistor can comprise a gate electrode and a load path between a source electrode and a drain electrode. The wake-up unit can comprise at least one capacitor coupled to the gate electrode. The capacitor is charged when the wake-up unit is exposed to an electromagnetic field, and the transistor changes from a non-conducting state to a conducting state when the capacitor is charged.

The at least one capacitor and the transistor can form a latching circuit, and the wake-up unit can further comprise a converter circuit configured to convert the electromagnetic field to a voltage, the voltage supplying the latching circuit comprising the capacitor and the transistor.

The specified period of time is one hour, one day, or one week. That is, the remote key can be deactivated and the quiescent current consumption effect can be reduced when the remote key is not in use for a certain time.

The remote key can comprise at least one antenna. With this at least one antenna it can communicate with the vehicle, and the electromagnetic field can be detected by means of the at least one antenna.

The remote key can be configured to communicate with the vehicle via the electromagnetic field.

The remote key can be configured to send inquiry signals to the vehicle to indicate the desire of a user to unlock or lock the vehicle.

Examples are now explained with reference to the drawings. In the drawings the same reference characters denote like features.
Figure 1 illustrates in a block diagram different components of an electronic remote key.
Figure 2 schematically illustrates a circuit diagram of an electronic remote key according to one example.
Figure 3 schematically illustrates in different diagrams the function of an electronic remote key according to one example.

In the following Figures, only such elements are illustrated that are useful for the understanding of the present invention. The electronic remote key described below may comprise more than the exemplary elements illustrated in the Figures. However, any additional elements that are not needed for the implementation of the present invention have been omitted for the sake of clarity.

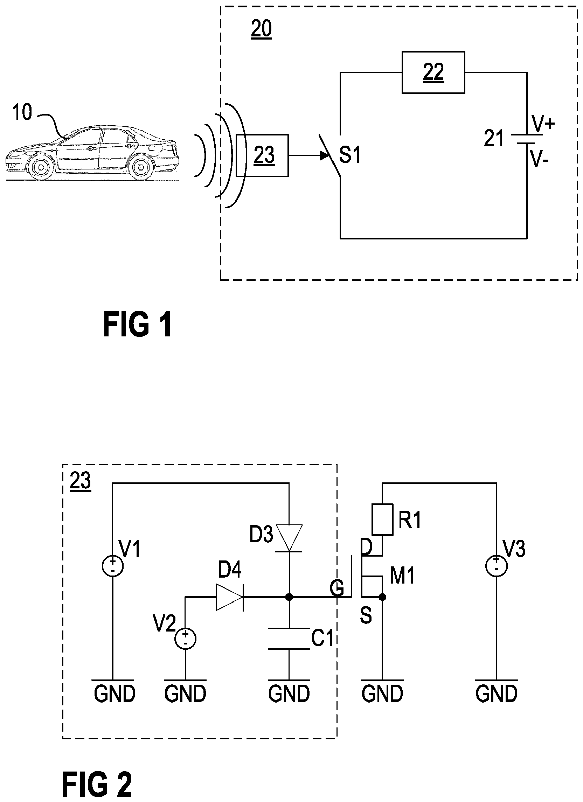

Figure 1 schematically illustrates an electronic remote key 20. The remote key 20 comprises a battery 21, a load 22, a switching element S1 and a wake-up unit 23. According to another example it is also possible that the switching element S1 is integrated in the wake-up unit 23. The battery 21 comprises a first terminal V+ and a second terminal V-. According to one example, the first terminal V+ provides a positive potential and the second terminal V- provides a negative potential. The load 22 and the switching element S1 are coupled in series between the first terminal V+ and the second terminal V-. When the switching element S1 is closed (conducting), the load 22 is powered by the battery 21. When the switching element S1 is open (non-conducting), the load 22 is switched off.

The electronic remote key 20 may be the key for a vehicle 10. Signals may be sent between the vehicle 10 and the electronic remote key 20. For example, the electronic remote key 20 may send inquiry signals to the vehicle 10 to indicate the desire of a user to unlock/lock the vehicle 10. Further, authentication signals may be sent between the electronic remote key 20 and the vehicle 10, for example, in order to prevent unauthorized users (unauthorized keys) from unlocking or starting the vehicle. Many other signals may be sent between the electronic remote key 20 and the vehicle 10 for many different applications.

For example, when the remote key 20 and a vehicle 10 it belongs to are delivered to a car dealer or end customer, and the remote key 20 is not yet needed to unlock or lock the vehicle 10, the switching element S1 can be open. In this way, the load 22 is completely disconnected from the battery 21 and any unwanted quiescent current consumption can be prevented. The load 22 can, for example, comprise one or more antennas and corresponding circuitry that is needed for communicating with the vehicle 10 to unlock or lock the vehicle 10. It is also possible that the load 22 comprises a regulator instead of or in addition to the one or more antennas, the regulator being configured to provide power to the different components of the remote key 20.

The electronic remote key 20 (load 22) may comprise different antennas, for example. A first antenna may be a low frequency (LF) antenna, for example. Low frequency signals may be sent at frequencies in the range between 30 to 300kHz. A second antenna may be a radio frequency (RF) or ultra-high frequency (UHF) antenna, for example. Radio frequency signals may be sent at frequencies in the range between 20kHz to 300GHz. The first antenna and the second antenna may be coupled to corresponding circuitries as well as to a microcontroller, for example. Such antenna circuitries for remote keys for vehicles are generally known and will therefore not be explained in further detail herein.

The different components are only schematically outlined in Figure 1. However, the wake-up unit 23 may comprise a plurality of components such as capacitors, resistors, diodes and/or transistors, for example. The precise arrangement of such components of wake-up unit 23 is not relevant for the present invention. One example of how the wake-up unit 20 can be implemented, however is described with respect to Figure 2 below.

The wake-up unit 23 is configured to open or close the switching element S1. As has been described above, the switching element S1 initially may be open (non-conducting). When the wake-up unit 23 is exposed to an electromagnetic field, it is configured to close the switching element S1 in order to connect the load 22 to the battery 21. The remote key 20 will then power up and can start a communication with the vehicle 10, for example.

The remote key 20 is usually in use for only short periods when locking or unlocking the vehicle 10 or while the vehicle 10 is in use. Most of the time, however, the remote key 20 does not need to communicate with the vehicle 10. Therefore, the wake-up unit 23 can be further configured to open the switching element S1 (switching element S1 non-conducting and load 22 not connected to battery 21) if the remote key 20 is inactive for a certain period of time. For example, the wake-up unit 23 can be configured to open the switching element S1 if the remote key 20 has been inactive for more than one hour, more than one day, or more than one week. Any other specified time period, however, is also possible. The time after which the switching element S1 is opened can either be set by the car manufacturer or can be set by a user itself. In this way, the load 22 can be disconnected from the battery 21 over night, for example, or when the user is on vacation and the vehicle 10 is not needed.

Once the wake-up unit 23 is again exposed to an electromagnetic field, it again closes the switching element S1 in order to power up the remote key 20. In this way, the quiescent current consumption effect of the remote key 20 can be significantly reduced and the lifetime of the battery 21 and therefore the remote key 20 can be increased.

The electromagnetic field the wake-up unit 23 is exposed to can be the electromagnetic field generated by the vehicle 10 to communicate with the remote key 20. That is, when a user carrying the remote key 20 approaches the vehicle 10, the wake-up unit 23 will be exposed to the electromagnetic field generated by the vehicle 10, the remote key 20 will be powered up and can subsequently communicate with the vehicle 10. The electromagnetic field, therefore, can be an electromagnetic field having a wavelength of, e.g., between 30kHz and 300kHz.

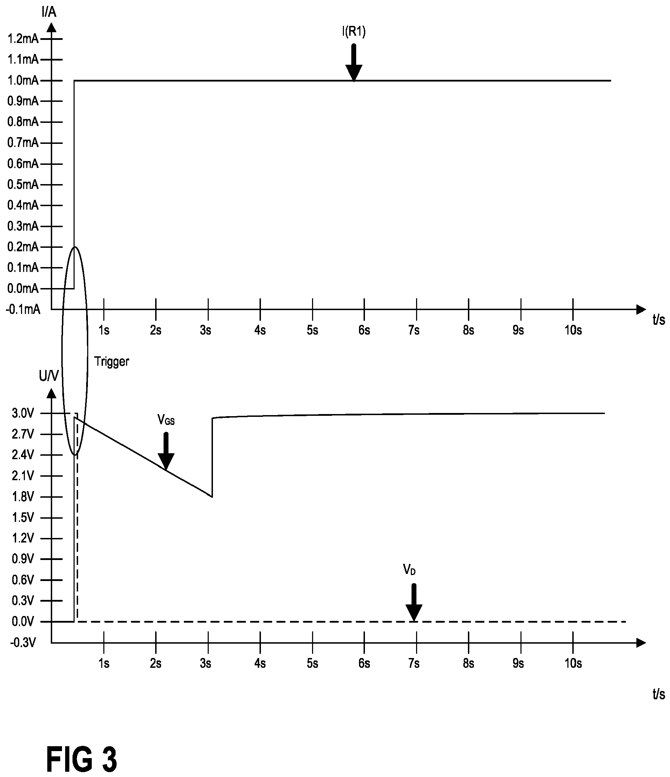

Now referring to Figure 2, an exemplary wake-up unit 23 is schematically illustrated. In this example, the switching element S1 comprises a transistor M1. The transistor M1 can be a MOSFET, for example. The transistor M1 comprises a gate electrode G and a load path between a drain electrode D and a source electrode S. The wake-up unit 23 can be coupled to the gate electrode G of the transistor M1, for example. The transistor M1 can be in a non-conducting state when no voltage is applied to its gate electrode G. That is, no current flows through the load path in the non-conducting state. In this state, a drain voltage V_{D} of the transistor M1 is positive and a gate-source voltage V_{GS} is zero (see, e.g., Figure 3). When a voltage is applied to the gate electrode G of the transistor M1 (gate-source voltage V_{GS} positive), the transistor M1 changes to a conducting state, that is, a current can flow through the load path (drain voltage V_{D} drops to zero). While the transistor M1 is in the conducting state, the load R1 is coupled to the battery V3 and will be supplied with energy.

The wake-up unit 23 can comprise an antenna or can be coupled to an antenna. When an electromagnetic field is detected by means of the antenna, for example, energy induced by the transmitter signal (electromagnetic field) is harvested (represented by voltage source V1 in Figure 2) and regulated to close the switching element S1. The wake-up unit 23, therefore, can comprise a converter circuit configured to convert the radiated electromagnetic field to a voltage supplying a latching circuit comprising the capacitor C1 and the switching element S1. When the load 22 is enabled by closing the switching element S1, a second voltage source V2 can keep the switching element S1 enabled (closed) as long as the wake-up unit 23 does not open the switching element S1 again. The diodes D3 and D4 are configured to block a mutual effect of the voltage sources V1 and V2 on each other.

The wake-up unit 23 in the example of Figure 2 comprises a capacitor C1. When the wake-up unit 23 is exposed to an electromagnetic field, the capacitor C1 will be charged and supplies a voltage to the gate electrode G of the transistor M1. In this way, the transistor M1 can change from the non-conducting state to the conducting state. Once the load R1 is supplied with energy from the battery V3, the circuitry is able to keep the transistor M1 in the conducting state.

Now referring to Figure 3, different currents and voltages in the remote key 20 are schematically illustrated. At the beginning, there is no current through the load R1 and no voltage at the gate electrode G of the transistor M1 (gate-source voltage V_{GS} = 0). When the remote key 20 is exposed to an electromagnetic field, the voltage at the gate electrode G rises rapidly (gate-source voltage V_{GS} > 0). This switches on the transistor M1 and it changes from a non-conducting state to a conducting state. That is, a current can flow through the load path of the transistor M1. The remote key 20 is woken up. As the transistor M1 switches from a non-conducting state to a conducting state, the drain voltage V_{D} of the transistor M1 drops to the same or at least close to the voltage level of the source terminal S. The gate-source voltage V_{GS} is required to remain above a predefined voltage level in order to keep the transistor M1 in the conducting state. The capacitor C1 is configured to keep the gate-source voltage V_{GD} above the predefined voltage level until the circuitry is able to keep the transistor M1 in the conducting state.

If the remote key 20 has not been used for a certain amount of time, it can be switched off again (load 22 disconnected from battery 21) in order to save energy and increase the lifetime of the battery 21 and remote key 20.

### List of reference signs

- 10: vehicle
- 20: electronic remote key
- 21: battery
- 22: load
- 23: wake-up unit
- S1: switching element
- V1, V2, V3: voltage sources
- R1: load
- M1: transistor
- C1: capacitor
- D3, D4: diodes

## Claims

1. An electronic remote key (20) for a vehicle (10), the remote key (20) comprising
a battery (21) comprising a first terminal (V+) and a second terminal (V-);
a load (22);
a switching element (S1); and
a wake-up unit (23), wherein
the load (22) and the switching element (S1) are coupled in series between the first terminal (V+) and the second terminal (V-) of the battery (21),
the wake-up unit (23), when exposed to an electromagnetic field, is configured to close the switching element (S1), and
the wake-up unit (23) is configured to open the switching element (S1) if the electronic remote key (20) is inactive for a specified period of time.

2. The electronic remote key (20) of claim 1, wherein the load (22) is supplied with energy from the battery (21) when the switching element (S1) is closed, and wherein the load (22) is not supplied with energy from the battery (21) if the switching element (S1) is open.

3. The electronic remote key (20) of claim 1 or 2, wherein the wake-up unit (23) is configured to close the switching element (S1) when exposed to an electromagnetic field with a frequency of between 30kHz and 300kHz.

4. The electronic remote key (20) of any of claims 1 to 3, wherein the switching element (S1) comprises a transistor (M1).

5. The electronic remote key (20) according to claim 4, wherein the transistor (M1) is a MOSFET.

6. The electronic remote key (20) according to claim 4 or 5, wherein
the transistor (M1) comprises a gate electrode (G) and a load path between a source electrode (S) and a drain electrode (D);
the wake-up unit (23) comprises at least one capacitor (C1) coupled to the gate electrode (G);
the capacitor (C1) is charged when the wake-up unit (23) is exposed to an electromagnetic field; and
the transistor (M1) changes from a non-conducting state to a conducting state when the capacitor (C1) is charged.

7. The electronic remote key (20) of claim 6, wherein the at least one capacitor (C1) and the transistor (M1) form a latching circuit, and wherein the wake-up unit (23) further comprises a converter circuit configured to convert the electromagnetic field to a voltage (V1), the voltage (V1 ) supplying the latching circuit comprising the capacitor (C1) and the transistor (M1).

8. The electronic remote key (20) of any of the preceding claims, wherein the specified period of time is one hour, one day, or one week.

9. The electronic remote key (20) of any of the preceding claims, further comprising at least one antenna.

10. The electronic remote key (20) of any of the preceding claims, wherein the remote key (20) is configured to communicate with the vehicle (10) via the electromagnetic field.

11. The electronic remote key (20) of claim 10, wherein the remote key (20) is configured to send inquiry signals to the vehicle (10) to indicate the desire of a user to unlock or lock the vehicle (10).
